# EUROPÄISCHE PATENTSCHRIFT

(11) **EP 2 380 193 B1**
(45) Veröffentlichungstag und Bekanntmachung des Hinweises auf die Patenterteilung: **19.12.2012**
(21) Anmeldenummer: 09737421.9
(22) Anmeldetag: 20.10.2009
(51) Int. Cl.: H01L 23/48, H01L 23/498, H01L 21/768

(54) **BAUTEIL MIT EINER DURCHKONTAKTIERUNG UND EIN VERFAHREN ZUR HERSTELLUNG EINES SOLCHEN BAUTEILS**
COMPONENT HAVING A VIA, AND A METHOD FOR PRODUCING THE COMPONENT
COMPOSANT PRÉSENTANT UNE CONNEXION TRAVERSANTE, ET PROCÉDÉ DE PRODUCTION D'UN TEL COMPOSANT

(30) Priorität: 16.12.2008 DE 102008054765
(43) Veröffentlichungstag der Anmeldung: 26.10.2011
(73) Patentinhaber: Robert Bosch GmbH, 70442 Stuttgart (DE)
(72) Erfinder: TRAUTMANN, Achim, 71229 Leonberg (DE); MUELLER, Thorsten, 71672 Marbach (DE)
(86) Internationale Anmeldenummer: PCT/EP2009/063733
(87) Internationale Veröffentlichungsnummer: WO 2010/069642

(56) Entgegenhaltungen:
- US-A1- 2005 059 217
- US-A1- 2007 045 780
- US-A1- 2008 286 899

## Beschreibung

### Stand der Technik

Die vorliegende Erfindung betrifft ein Bauteil mit einer Durchkontaktierung zur elektrischen Verbindung zwischen einer ersten und einer zweiten Ebene eines Substrates gemäß dem Oberbegriff des Anspruchs 1 sowie ein Verfahren zur Herstellung eines solchen Bauteils gemäß dem Oberbegriff des Anspruchs 8, wie jeweils aus der US 2008/286899 A1 bekannt.

Aus dem Stand der Technik sind Bauteile mit einer Durchkontaktierung an sich bekannt. So wird etwa in EP 1 187 192 A2 ein Verfahren zur Herstellung einer elektrisch leitenden Verbindung durch eine oder mehrere isolierende Schichten beschrieben, wobei mittels eines mit einem leitenden Material gefüllten Kontaktsloches ein elektrischer Stromfluss zwischen zwei elektrisch leitenden Stellen, die sich in unterschiedlichen Strukturebenen befinden, ermöglicht wird.

Weiter ist es bekannt, bei der Durchkontaktierung eine Isolierschicht zwischen einem Substrat und einem elektrisch leitenden Material anzuordnen. Gemäß der Lehre nach DE 102 44 077 B4 wird ein Substrat gebildet, wobei das Loch anschließend mit einer Isolierschicht ausgekleidet wird. Schließlich wird durch ein galvanisches Ausfüllen des Loches mit einem metallischen Material eine elektrische Verbindung durch das Loch hergestellt. Die Isolierschicht hat dabei die Aufgabe, das Substrat von der metallischen Füllung des Loches elektrisch zu trennen und eine Diffusion von Metallionen in das Substrat zu verhindern. Es wird vorgeschlagen, ein Isolierschicht aus Siliziumoxid oder aus Siliziumoxid und Siliziumnitrid vorzusehen. Als metallische Füllung werden die Materialien Kupfer, Nickel oder eine Nickel-Eisenlegierung genannt.

Ähnlich ist es aus DE 10 2006 060 250 B3 ein Verfahren bekannt, mit dem Durchkontaktierungen mittels galvanischer Abscheidung eines Metalls hergestellt werden können. Ein Wafer wird gemäß der Lehre hierfür zunächst mit Bohrungen versehen, wobei im Innenbereich der Bohrung eine Diffusionsbarriere angeordnet wird, welche die Bohrung vollständig auskleidet. Die Diffusionsbarriere dient der Verhinderung der Diffusion des später abzuscheidenden Metalls der Durchkontaktierung in das Halbleitermaterial des Wafers. Während die Diffusionsbarriere aus Tantalnitrid gebildet werden kann, erfolgt die Füllung der Bohrung durch galvanische Abscheidung von Kupfer.

An eine Isolations- bzw. Barriereschicht bei der Durchkontaktierung werden bestimmte Anforderungen gestellt, die möglichst alle gleichzeitig erfüllt werden sollten: Die Schicht sollte eine ausreichend stark ausgeprägte, elektrisch isolierende Eigenschaft aufweisen, um einen elektrischen Fluss durch die Schicht hindurch zuverlässig zu verhindern. Weiter muss die Schicht eine niedrige Diffusionskonstante aufweisen, um einen Materialfluss durch die Schicht hindurch ebenfalls zuverlässig zu verhindern. Schließlich ist es für die industrielle Anwendung wichtig, dass die Herstellung der Schicht kontrolliert und zuverlässig gewährleistet werden kann und in ein bestehendes Herstellungsverfahren des Bauteils einfach und ohne großen Aufwand integriert werden kann.

### Vorteile der Erfindung

Das erfindungsgemäße Bauteil mit einer Durchkontaktierung nach Anspruch 1 bzw. das Verfahren zu seiner Herstellung nach Anspruch 8 hat den Vorteil gegenüber dem Stand der Technik, dass für die Durchkontaktierung eine Zwischenschicht bereitgestellt wird, die alle oben genannten Anforderungen optimal erfüllt. Insofern bietet die Erfindung die Möglichkeit, ein Bauteil mit einer Durchkontaktierung bereitzustellen, bei dem man keinen Kompromiss eingehen muss zwischen den verschiedenen Anforderungen an die Zwischenschicht.

Erreicht wird dieser Vorteil durch eine bestimmte Materialauswahl für die Schicht zwischen einem Substrat und einem elektrisch leitenden Material.

Es ist weiter vorteilhaft, dass durch die erfindungsgemäße Materialauswahl sogar ermöglicht wird, in nur einem Schichtbildungsprozess neben der Zwischenschicht auch eine leitende Schicht für die Durchkontaktierung bereitzustellen.

Vorteilhafte Weiterbildungen der Erfindung sind in den Unteransprüchen angegeben und in der Beschreibung beschrieben.

### Zeichnung

Ausführungsbeispiele der Erfindung werden anhand der Zeichnungen und der nachfolgenden Beschreibung näher erläutert. Es zeigen:
Figur 1 ein Bauteil mit einem Bohrloch in Form eines Blindlochs (Boden des Bohrlochs ist ungeöffnet),
Figur 2 ein Bauteil mit einem Bohrloch in Form eines Durchgangslochs (Boden des Bohrlochs ist geöffnet), und
Figur 3 ein Ausführungsbeispiel des erfindungsgemäßen Bauteils mit einer Durchkontaktierung.

### Beschreibung der Ausführungsbeispiele

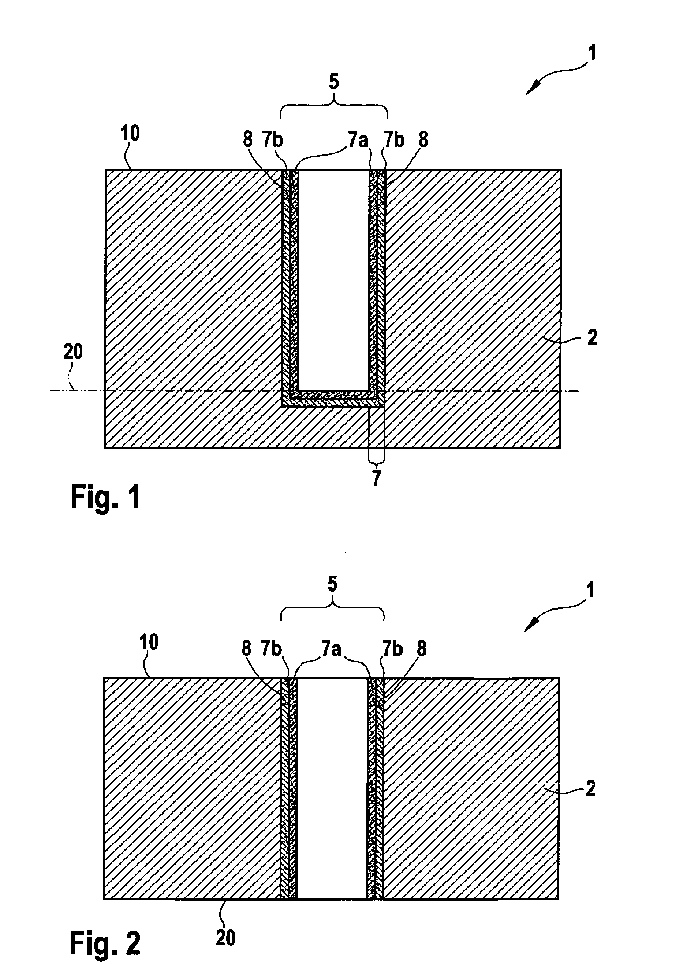

Mit Hilfe der Figuren 1, 2 und 3 werden das erfindungsgemäße Verfahren zur Herstellung eines Bauteils 1 mit einer Durchkontaktierung zur elektrischen Verbindung zwischen einer ersten 10 und einer zweiten Ebene 20 eines Substrates 2 und das damit hergestellte erfindungsgemäße Bauteil 1 in seinen vielen Ausführungsformen näher beschrieben. Zur Vermeidung von Wiederholungen sollen dabei sämtliche Merkmale, die als ein Verfahrensmerkmal formuliert werden, auch als ein strukturelles Merkmal offenbart gelten, sofern dies sinnvoll ist, und umgekehrt.

Das erfindungsgemäße Verfahren umfasst grundsätzlich die folgenden Schritte, die nacheinander durchgeführt werden:
a) Bereitstellen eines Substrates 2,
b) Bilden eines Bohrloches 5 mit einer Innenwand 8 zwischen einer ersten 10 und einer zweiten Ebene 20 des Substrates 2;
c) Abscheiden einer Zwischenschicht 7 auf die Innenwand 8, wobei die Zwischenschicht 7 elektrisch isolierendes SiC umfasst; und
d) Abscheiden einer Leitschicht 6 aus einem elektrisch leitfähigem Material auf die Zwischenschicht 7, so dass eine elektrische Verbindung zwischen der ersten 10 und der zweiten Ebene 20 des Substrates 2 gebildet wird.

Der Erfindung liegt die Erkenntnis zugrunde, dass Siliziumcarbid ein äußerst geeignetes Material für eine Zwischenschicht 7 zwischen der Innenwand 8 des Bohrloches 5 und der Leitschicht 6 darstellt. Erstens zeichnet sich SiC aufgrund seiner großen Bandlücke durch eine niedrige elektrische Leitfähigkeit und hohe elektrische Durchschlagfestigkeit aus. Weiter weist das Material aufgrund seiner hohen Packungsdichte eine niedrige Diffusionskonstante auf. Zudem ist das Material thermisch exzellent leitfähig.

Im Schritt a) wird ein Substrat 2, das mit einer Durchkontaktierung versehen werden soll, bereitgestellt. Bevorzugt wird als Substrat 2 ein Halbleitermaterial favorisiert, insbesondere ein Si-Substrat.

Je nach Bedarf kann im Schritt b) das Bohrloch 5 mittels eines DRIE(deep reactive ion etching)- Prozesses oder mittels eines Laserbohrverfahrens gebildet werden. Auf jeden Fall wird durch den Schritt b) ein Bohrloch 5 mit einer Innenwand 8 erzeugt, wobei das Bohrloch 5 zwischen einer ersten 10 und einer zweiten Ebene 20 des Substrats 2 angeordnet ist. Dabei kann, wie in Fig. 1 dargestellt, ein Bohrloch 5 in Form eines Blindlochs erzeugt werden, d.h. der Boden des Bohrlochs 5 ist nicht geöffnet. Dieses Blindloch kann jedoch je nach Bedarf nach Abscheidung der Zwischenschicht 7, also nach Schritt c), geöffnet werden. Mit der Öffnung des Bodens wird der Zustand gemäß Fig. 1 in einen Zustand gemäß Fig. 2 überführt. Man kann jedoch auch gleich im Schritt b) ein Bohrloch in Form eines Durchgangslochs erzeugen.

Im Schritt c) wird erfindungsgemäß Siliziumcarbid für die Zwischenschicht 7 abgeschieden. Ein kontrollierter, zuverlässiger SiC-Abscheideprozess wird mittels aktueller Technologie gewährleistet. Es wird vorgeschlagen, SiC bevorzugt über einen CVD(chemical vapour deposition)-Prozess oder über ein Epitaxieverfahren abzuscheiden.

Es kann vorgesehen werden, dass im Schritt c) die Zwischenschicht 7 vorteilhaft eine Barriereschicht 7a und/oder eine Isolationsschicht 7b umfasst. Für den Fall, dass die Zwischenschicht 7 mit einer Barriereschicht 7a und einer Isolationsschicht 7b als Teilschichten abgeschieden wird, grenzt die Barriereschicht 7a direkt an der Leitschicht 6. Damit wird eine geeignete Schichtfolge auf der Innenwand 8 des Bohrlochs 5 gebildet: Innenwand 8/Isolationsschicht 7b / Barriereschicht 7a / Leitschicht 6. Dabei ist es möglich, dass die Isolationsschicht 7b wie aus dem Stand der Technik bekannt aus einem Oxid, insbesondere Si-Oxid, oder einem Nitrid, insbesondere Si-Nitrid, besteht, während die Barriereschicht 7a jedoch nun abweichend vom Stand der Technik aus SiC gebildet wird.

Eine besonders vorteilhafte Ausführungsform sieht vor, dass im Schritt c) die Zwischenschicht 7 mit einer Barriereschicht 7a und einer Isolationsschicht 7b als Teilschichten abgeschieden wird, wobei nun beide Teilschichten aus einem elektrisch isolierenden SiC gebildet werden. Die Zwischenschicht 7 aus SiC dient also als eine Isolationsschicht 7b und als eine Barriereschicht 7a.

Im Schritt d) wird die Leitschicht 6 ebenfalls aus SiC abgeschieden, und zwar aus einem dotierten, elektrisch leitfähigen SiC. Um ein elektrisch leitfähiges SiC zu erhalten, wird eine ausreichend hohe Dotierung des Materials gezielt erzeugt. Da die Stärke der Dotierung bei der Erzeugung einer SiC-Schicht definiert variiert werden kann, ist es bevorzugt vorgesehen, dass das Abscheiden einer Zwischenschicht 7 gemäß Schritt c) und das Abscheiden einer Leitschicht 6 gemäß Schritt d) in einem SiC-Abscheideprozess durchzuführen, wobei die Dotierungsstärke während des Abscheideprozesses zunimmt. Durch die in-situ Variation der Dotierungsstärke während eines Abscheideprozesses vereinfacht sich das gesamte Verfahren signifikant. Es wird noch darauf hingewiesen, dass ein nachträgliches Rückschleifen oder Rückätzen des Substrats 2 notwendig ist, sofern im Schritt b) ein Blindloch erzeugt wurde und die Leitschicht 6 freigelegt werden soll.

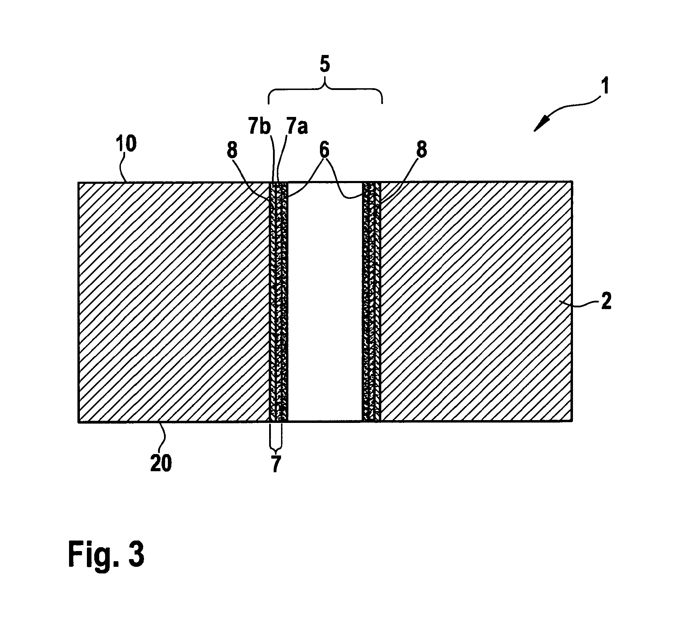

Ein Bauteil 1, das mit solch einem Verfahren hergestellt ist, wird in Fig. 3 gezeigt. Das Bohrloch 5 ist auf der Innenwand 8 beschichtet mit SiC-Material, wobei die Dotierung des SiC-Materials ausgehend von der Innenwand 8 in Richtung zur Bohrlochmitte zunimmt. So entstehen innerhalb des SiC-Materials mehrere Schichtebenen mit unterschiedlicher elektrischer Leitfähigkeit: Die Isolationsschicht 7b, die Barriereschicht 7a und die elektrisch leitfähige Leitschicht 6. Dabei ist die Zwischenschicht 7 niedrig bzw. kompensiert dotiert, während die Leitschicht 6 hochdotiert ist.

Nach Schritt d) kann noch eine galvanische oder chemische Verstärkung der Leitschicht 6 durchgeführt werden.

Es sei noch darauf hingewiesen, dass in allen Figuren 1-3 der Übergang zwischen den einzelnen Schichten, nämlich zwischen der Isolationsschicht 7b, der Barriereschicht 7a und der elektrisch leitfähigen Leitschicht 6, scharf und abrupt dargestellt wurde. Je nach Bedarf können aber einzelne oder auch alle Übergänge zwischen den genannten Schichten fließend erfolgen, so zum Beispiel im Falle einer Zwischenschicht 7 und einer Leitschicht 6 aus einem SiC-Material, wenn die Dotierungsstärke nicht abrupt, sondern allmählich variiert wird.

Auf eine zeichnerische Darstellung dieser fließenden Übergänge der Schichten wurde aus Gründen der Übersichtlichkeit verzichtet.

Das Bauteil 1 kann übrigens ein mikroelektronisches bzw. ein mikroelektromechanisches Bauteil 1 sein.

## Patentansprüche

1. Bauteil (1) mit einer Durchkontaktierung zur elektrischen Verbindung zwischen einer ersten (10) und einer zweiten Ebene (20) eines Substrates (2), wobei das Substrat (2) ein Bohrloch (5) mit einer Innenwand (8) aufweist, die beschichtet ist mit einer Leitschicht (6) aus einem elektrisch leitfähigen Material, wobei zwischen der Innenwand (8) und der Leitschicht (6) eine Zwischenschicht (7) angeordnet ist,
wobei die Zwischenschicht (7) elektrisch isolierendes SiC umfasst,
**dadurch gekennzeichnet,**
**dass** die Leitschicht (6) aus einem dotierten, elektrisch leitfähigen SiC gebildet ist.

2. Bauteil (1) nach Anspruch 1,
**dadurch gekennzeichnet,**
**dass** die Zwischenschicht (7) eine Barriereschicht (7a) und/oder eine Isolationsschicht (7b) umfasst.

3. Bauteil (1) nach Anspruch 2,
**dadurch gekennzeichnet,**
**dass** die Zwischenschicht (7) eine Barriereschicht (7a) und eine Isolationsschicht (7b) als Teilschichten umfasst, wobei die Barriereschicht (7a) direkt an der Leitschicht (6) grenzt.

4. Bauteil (1) nach Anspruch 2 oder 3,
**dadurch gekennzeichnet,**
**dass** die Barriereschicht (7a) aus elektrisch isolierendem SiC gebildet ist, während die Isolationsschicht (7b) aus einem Oxid oder einem Nitrid besteht.

5. Bauteil (1) nach Anspruch 2 oder 3,
**dadurch gekennzeichnet,**
**dass** die Barriereschicht (7a) und die Isolationsschicht (7b) aus elektrisch isolierendem SiC gebildet sind.

6. Bauteil (1) nach Anspruch 1, **dadurch gekennzeichnet,**
**dass** die Zwischenschicht(7) und die Leitschicht (6) aus einer gemeinsamen SiC Schicht gebildet ist, wobei die Überführung der isolierenden Zwischenschicht (7) in eine Leitschicht (6) innerhalb der einen SiC-Schicht durch eine zunehmende Dotierung von der Zwischenschicht (7) zur Leitschicht (6) erzielt wird.

7. Bauteil (1) nach einem der Ansprüche 1 bis 6,
**dadurch gekennzeichnet,**
**dass** das Substrat aus einem Halbleitermaterial, insbesondere Silizium, gebildet ist.

8. Verfahren zur Herstellung eines Bauteils (1) mit einer Durchkontaktierung zur elektrischen Verbindung zwischen einer ersten (10) und einer zweiten Ebene (20) eines Substrates (2), umfassend die Schritte:
a) Bereitstellen eines Substrates (2) insbesondere eines Si-Substrates;
b) Bilden eines Bohrlochs (5) mit einer Innenwand (8) zwischen einer ersten (10) und einer zweiten Ebene (20) des Substrates (2);
c) Abscheiden einer Zwischenschicht (7) auf die Innenwand (8), wobei die Zwischenschicht (7) elektrisch isolierendes SiC umfasst; und
d) Abscheiden einer Leitschicht (6) aus einem elektrisch leitfähigem Material auf die Zwischenschicht (7), so dass eine elektrische Verbindung zwischen der ersten (10) und der zweiten Ebene (20) des Substrates (2) gebildet wird;
**dadurch gekennzeichnet,**
**dass** im Schnitt d) eine Leitschicht (6) aus einem dotierten, elektrisch leitfähigen SiC abgeschieden wird.

9. Verfahren nach Anspruch 8,
**dadurch gekennzeichnet,**
**dass** im Schritt b) das Bohrloch (5) mittels eines DRIE(deep reactive ion etching)-Prozesses oder mittels eines Laserborhverfahrens gebildet wird.

10. Verfahren nach Anspruch 8 oder 9,
**dadurch gekennzeichnet,**
**dass** im Schritt c) das SiC-Material für die Zwischenschicht (7) über einen CVD(chemical vapour deposition)-Prozess oder über ein Epitaxieverfahren abgeschrieben wird.

11. Verfahren nach einem der Anspruch 8 bis 9,
**dadurch gekennzeichnet,**
**dass** im Schritt c) eine Zwischenschicht (7) mit einer Barriereschicht (7a) und einer Isolationsschicht (7b) als Teilschichten abgeschieden wird, wobei die Barriereschicht (7a) direkt an der Leitschicht (6) grenzt.

12. Verfahren nach Anspruch 11,
**dadurch gekennzeichnet,**
**dass** im Schritt c) eine Zwischenschicht (7) mit einer Barriereschicht (7a) und einer Isolationsschicht (7b) als Teilschichten abgeschieden wird, wobei beide Teilschichten aus einem elektrisch isolierenden SiC gebildet werden.

13. Verfahren nach einem der Ansprüche 8 bis 12,
**dadurch gekennzeichnet,**
**dass** das Abschneiden einer Zwischenschicht (7) gemäß Schritt c) und das Abscheiden einer Leitschicht (6) gemäß Schritt d) in einem SiC-Abscheideprozess durchgeführt werden, wobei die Dotierungsstärke während des Abscheideprozesses zunimmt.

## Claims

1. Component (1) having a via for electrical connection between a first plane (10) and a second plane (20) of a substrate (2), wherein the substrate (2) has a bore hole (5) with an inner wall (8) which is coated with a conductive layer (6) made of an electrically conductive material, wherein an intermediate layer (7) is arranged between the inner wall (8) and the conductive layer (6),
wherein the intermediate layer (7) comprises electrically insulating SiC,
**characterized**
**in that** the conductive layer (6) is formed from a doped, electrically conductive SiC.

2. Component (1) according to Claim 1,
**characterized**
**in that** the intermediate layer (7) comprises a barrier layer (7a) and/or an insulation layer (7b).

3. Component (1) according to Claim 2,
**characterized**
**in that** the intermediate layer (7) comprises a barrier layer (7a) and an insulation layer (7b) as partial layers, wherein the barrier layer (7a) directly adjoins the conductive layer (6).

4. Component (1) according to Claim 2 or 3,
**characterized**
**in that** the barrier layer (7a) is formed from electrically insulating SiC, whereas the insulation layer (7b) consists of an oxide or a nitride.

5. Component (1) according to Claim 2 or 3,
**characterized**
**in that** the barrier layer (7a) and the insulation layer (7b) are formed from electrically insulating SiC.

6. Component (1) according to Claim 1,
**characterized**
**in that** the intermediate layer (7) and the conductive layer (6) are formed from a common SiC layer, wherein the transition of the insulating intermediate layer (7) into a conductive layer (6) within the one SiC layer is achieved by a doping which increases from the intermediate layer (7) to the conductive layer (6).

7. Component (1) according to one of Claims 1 to 6,
**characterized**
**in that** the substrate is formed from a semiconductor material, in particular silicon.

8. Process for producing a component (1) having a via for electrical connection between a first plane (10) and a second plane (20) of a substrate (2), said process comprising the following steps:
a) providing a substrate (2), in particular an Si substrate;
b) forming a bore hole (5) with an inner wall (8) between a first plane (10) and a second plane (20) of the substrate (2);
c) depositing an intermediate layer (7) on the inner wall (8), wherein the intermediate layer (7) comprises electrically insulating SiC; and
d) depositing a conductive layer (6) made of an electrically conductive material on the intermediate layer (7), such that an electrical connection is formed between the first plane (10) and the second plane (20) of the substrate (2);
**characterized**
**in that**, in step d), a conductive layer (6) made of a doped, electrically conductive SiC is deposited.

9. Process according to Claim 8,
**characterized**
**in that**, in step b), the bore hole (5) is formed by means of a DRIE (deep reactive ion-etching) process or by means of a laser drilling process.

10. Process according to Claim 8 or 9,
**characterized**
**in that**, in step c), the SiC material for the intermediate layer (7) is deposited by way of a CVD (chemical vapour deposition) process or by way of an epitaxy process.

11. Process according to either of Claims 8 and 9,
**characterized**
**in that**, in step c), an intermediate layer (7) comprising a barrier layer (7a) and an insulation layer (7b) as partial layers is deposited, wherein the barrier layer (7a) directly adjoins the conductive layer (6).

12. Process according to Claim 11,
**characterized**
**in that**, in step c), an intermediate layer (7) comprising a barrier layer (7a) and an insulation layer (7b) as partial layers is deposited, wherein both partial layers are formed from an electrically insulating SiC.

13. Process according to one of Claims 8 to 12,
**characterized**
**in that** the deposition of an intermediate layer (7) as per step c) and the deposition of a conductive layer (6) as per step d) are carried out in an SiC deposition process, wherein the doping intensity increases during the deposition process.

## Revendications

1. Composant (1) doté d'un passage de contact qui assure la liaison électrique entre un premier plan (10) et un deuxième plan (20) d'un substrat (2),
le substrat (2) présentant une perforation (5) dotée d'une paroi intérieure (8) revêtue d'une couche conductrice (6) en matériau électriquement conducteur,
une couche intermédiaire (7) étant disposée entre la paroi intérieure (8) et la couche conductrice (6),
la couche intermédiaire (7) comportant du SiC électriquement isolant,
**caractérisé en ce que**
la couche conductrice (6) est formée d'un SiC dopé électriquement conducteur.

2. Composant (1) selon la revendication 1, **caractérisé en ce que** la couche intermédiaire (7) comporte une couche de barrière (7a) et/ou une couche isolante (7b).

3. Composant (1) selon la revendication 2, **caractérisé en ce que** la couche intermédiaire (7) comporte une couche de barrière (7a) et une couche isolante (7b) réalisées sous la forme de couches partielles, la couche de barrière (7a) étant directement adjacente à la couche conductrice (6).

4. Composant (1) selon les revendications 2 ou 3, **caractérisé en ce que** la couche de barrière (7a) est formé de SiC électriquement isolant alors que la couche isolante (7b) est constituée d'un oxyde ou d'un nitrure.

5. Composant (1) selon les revendications 2 ou 3, **caractérisé en ce que** la couche de barrière (7a) et la couche isolante (7b) sont formées de SiC électriquement isolant.

6. Composant (1) selon la revendication 1, **caractérisé en ce que** la couche intermédiaire (7) et la couche conductrice (6) sont formées d'une couche commune de SiC, la transition entre la couche intermédiaire isolante (7) et la couche conductrice (6) à l'intérieur d'une couche de SiC est obtenue par une augmentation du dopage de la couche intermédiaire (7) à la couche conductrice (6).

7. Composant (1) selon l'une des revendications 1 à 6, **caractérisé en ce que** le substrat est formé d'un matériau semi-conducteur et en particulier de silicium.

8. Procédé de fabrication d'un composant (1) doté d'un passage de contact qui assure la liaison électrique entre un premier plan (10) et un deuxième plan (20) d'un substrat (2), le procédé comportant les étapes qui consistent à :
a) prévoir un substrat (2), en particulier un substrat de Si,
b) former une perforation (5) dotée d'une paroi intérieure (8) entre un premier plan (10) et un deuxième plan (20) du substrat (2),
c) déposer une couche intermédiaire (7) sur la paroi intérieure (8), la couche intermédiaire (7) comportant du SiC électriquement isolant et
d) déposer une couche conductrice (6) en un matériau électriquement conducteur sur la couche intermédiaire (7) de manière à former une liaison électrique entre le premier plan (10) et le deuxième plan (20) du substrat (2),
**caractérisé en ce que**
à l'étape d), une couche conductrice (6) en SiC dopé électriquement conducteur est déposée.

9. Procédé selon la revendication 8, **caractérisé en ce qu'**à l'étape b), la perforation (5) est formée par une opération DRIE ("deep reactive ion etching" - gravure profonde à ions réactifs) ou au moyen d'un procédé de forage au laser.

10. Procédé selon les revendications 8 ou 9, **caractérisé en ce qu'**à l'étape c), le matériau de SiC prévu pour la couche intermédiaire (7) est déposé par une opération de CVD ("chemical vapour deposition" - dépôt chimique de vapeur) ou une opération d'épitaxie.

11. Procédé selon l'une des revendications 8 et 9, **caractérisé en ce qu'**à l'étape c), une couche intermédiaire (7) formée d'une couche de barrière (7a) et d'une couche isolante (7b) réalisées sous la forme de couches partielles est déposée, la couche de barrière (7a) étant directement adjacente à la couche conductrice (6).

12. Procédé selon la revendication 11, **caractérisé en ce qu'**à l'étape c), une couche intermédiaire (7) formée d'une couche de barrière (7a) et d'une couche isolante (7b) réalisées sous la forme de couches partielles est déposée, les deux couches partielles étant formées d'un SiC électriquement isolant.

13. Procédé selon l'une des revendications 8 à 12, **caractérisé en ce que** le dépôt d'une couche intermédiaire (7) au cours de l'étape c) et le dépôt d'une couche conductrice (6) au cours de l'étape d) sont réalisés dans une opération de dépôt de SiC, l'intensité du dopage augmentant au cours de l'opération de dépôt.
